Europäisches Patentamt

(19) European Patent Office

Office européen des brevets

(11) Numéro de publication: **0 136 197**
**A1**

(12) **DEMANDE DE BREVET EUROPEEN**

(21) Numéro de dépôt: **84401540.4**

(22) Date de dépôt: **20.07.84**

(51) Int. Cl.⁴: **C 30 B 11/00, C 30 B 27/00**

(30) Priorité: **29.07.83 FR 8312547**

(43) Date de publication de la demande: **03.04.85**
**Bulletin 85/14**

(84) Etats contractants désignés: **DE FR GB IT NL**

(71) Demandeur: **COMMISSARIAT A L'ENERGIE ATOMIQUE**
**Etablissement de Caractère Scientifique Technique et**
**Industriel, 31/33, rue de la Fédération, F-75015 Paris (FR)**

(72) Inventeur: **Potard, Claude, 9, Boulevard Jomardière,**
**F-38120 Saint Egreve (FR)**

(74) Mandataire: **Mongrédien, André et al, c/o**
**BREVATOME 25, rue de Ponthieu, F-75008 Paris (FR)**

(54) Procédé et dispositif pour l'élaboration d'une pièce par moulage dans un milieu liquide.

㉗ Procédé et dispositif d'élaboration d'une pièce par moulage dans un milieu liquide.

On forme une masse liquide homogène d'un premier matériau (3) dans un bain liquide d'un deuxième matériau (2) dont la température de fusion est inférieure à celle du premier matériau, on comprime ladite masse liquide par le déplacement d'au moins une partie (4a) d'un moyen de moulage, on abaisse la température pour qu'au moins le premier matériau se solidifie et on extrait la pièce ainsi réalisée.

Application à la réalisation de plaques de silicium.

EP 0 136 197 A1

## Procédé et dispositif pour l'élaboration d'une pièce par moulage dans un milieu liquide

La présente invention a pour objet un procédé d'élaboration d'une pièce par moulage dans lequel le matériau constitutif de la pièce, notamment le silicium, est séparé des parois d'un moule ou d'une pièce de forme par un liquide protecteur.

Il est connu de réaliser des pièces par solidification à travers une pièce de forme en séparant les pièces à élaborer des parois de la pièce de forme par un liquide protecteur car la présence de celui-ci permet d'éviter des réactions chimiques parasites entre le matériau à élaborer et le matériau constituant les parois de la pièce de forme.

La présente invention a pour objet un procédé de ce type utilisant un liquide protecteur qui permet d'obtenir d'une manière simple et rapide un objet ou une pièce ayant une forme donnée par moulage sans contact direct avec les parois du moule.

Selon la principale caractéristique du procédé objet de l'invention, celui-ci comprend les étapes suivantes :

- on forme, dans une cuve contenant un moyen de moulage, une masse liquide homogène d'un premier matériau enrobé par un bain liquide d'un deuxième matériau non miscible avec le premier matériau, ce deuxième matériau ayant une température de fusion inférieure à celle du premier matériau, présentant une grande inertie chimique vis-à-vis du premier matériau et un pouvoir mouillant vis-à-vis du moyen de moulage supérieur à celui du premier matériau,

- on comprime cette masse par le rapprochement d'au moins deux parties d'un moyen de moulage, l'une au moins de ces dernières présentant au moins une paroi percée de trous et ayant une forme telle qu'en posi-

B 7812.3   JR

tion rapprochée les deux parties définissent une cavité ayant la forme de l'objet à élaborer,
- on abaisse la température pour qu'au moins le premier matériau se solidifie, et
- on extrait la pièce ainsi solidifiée.

    Dans un premier mode de mise en oeuvre,
l'extraction du premier matériau solidifié se fait
alors que le deuxième matériau est encore à l'état
liquide. Dans un deuxième mode de mise en oeuvre, on
extrait le premier matériau après solidification complète du deuxième. Dans ce cas, il est commode, si les
matériaux le permettent, d'utiliser une cuve dont les
parois se rabattent, facilitant la préhension de
l'objet réalisé.

    Les premier et deuxième matériaux peuvent
avoir des densités voisines lorsqu'ils sont à l'état
liquide : ceci permet d'utiliser des moules dont les
parois ont une orientation quelconque, par exemple
verticale.

    Dans un deuxième cas, les premier et deuxiè-
me matériaux ont des densités respectives quelconques
lorsqu'ils sont à l'état liquide ; ce deuxième cas
s'applique au moulage de matériaux métalliques ou
semi-métalliques en apesanteur ou en micro-gravité,
par exemple à bord d'un satellite en orbite autour de
la terre.

    Enfin, dans un troisième cas, le premier ma-
tériau a une densité supérieure à celle du deuxième
matériau ; il faut alors utiliser des moules dont les
parois sont horizontales. Dans tous les cas, on réalise une solidification orientée du premier matériau.

    Le procédé selon l'invention s'applique au
moulage de plaques ainsi que toutes autres formes géométriques pleines ou creuses (tubes, cubes, parallélépipèdes, calottes sphériques...). Une application du
procédé selon l'invention est la réalisation d'objets

semiconducteurs. Cette application est importante dans le cas du silicium.

Dans ce dernier cas, le deuxième matériau peut être par exemple un mélange de fluorure de calcium et de fluorure de magnésium dont la composition correspond à la composition eutectique et les différentes parties du moyen de moulage peuvent avantageusement être réalisées en graphite.

La solidification orientée du silicium et son extraction peuvent s'effectuer par une mise en contact d'une tige avec la partie encore liquide du premier matériau, en fin de solidification, puis en laissant solidifier cette partie du premier matériau pour réaliser une fixation par collage sur la tige solide et en extrayant le premier matériau du moule par l'intermédiaire de cette tige.

La tige d'extraction est en métal réfractaire ou en oxyde réfractaire, préférentiellement mouillé par le premier matériau, et on la sépare du matériau solidifié après refroidissement complet. Une autre application du procédé selon l'invention est la fabrication d'objets en alliages des éléments appartenant aux groupes III-V de la classification périodique. Dans ce cas, le deuxième matériau est choisi dans le groupe constitué par le trioxyde de bore et l'eutectique chlorure de potassium-chlorure de lithium. Quant au moyen de moulage, il est réalisé de préférence en quartz ou en nitrure de bore.

La solidification du premier matériau peut se faire par une méthode de solidification orientée et le procédé objet de l'invention trouve une application intéressante à l'élaboration de matériaux par moulage en microgravité.

L'invention a également pour objet un dispositif pour la mise en oeuvre de ce procédé. Suivant la

principale caractéristique de ce dispositif, celui-ci comprend :

- une cuve apte à contenir le deuxième matériau,
- des moyens de chauffage du deuxième matériau,
- des moyens de formation d'une masse liquide du premier matériau dans le bain liquide du deuxième matériau,
- un moyen de moulage dont au moins une partie est déplaçable entre une position de repos et une position de moulage, ledit moyen de moulage présentant au moins une paroi percée de trous,
- des moyens de déplacement de ladite partie mobile entre la position de repos et la position de moulage,
- des moyens de refroidissement pour la solidification d'au moins le premier matériau, et
- un moyen d'extraction du premier matériau solidifié.

Dans un premier mode de réalisation, le moyen de moulage comprend au moins deux parties déplaçables à l'intérieur de la cuve. Dans un deuxième mode de réalisation, le moyen de moulage comporte un piston déplaçable en direction d'une partie fixe de la cuve.

Suivant une caractéristique particulière du dispositif objet de l'invention, les moyens d'extraction du premier matériau une fois solidifié comprennent au moins une griffe comportant un montant et un pied, le montant pouvant coulisser dans une glissière prévue sur la face interne d'une paroi de la cuve et le pied pouvant être reçu dans un logement ménagé sur le fond de la cuve.

Suivant un autre mode de réalisation, utilisable lorsqu'on laisse solidifier les deux matériaux avant d'extraire la pièce réalisée, la cuve comporte un fond et des parois latérales dont une au moins est détachable du fond, permettant ainsi l'extraction de

B 7812.3  JR

la pièce réalisée après solidification complète du premier et du deuxième matériaux.

Dans certains cas, le matériau constitutif de la pièce augmente ou diminue de volume en se solidifiant. Il faut donc prévoir des moyens permettant d'exercer une force calibrée sur le premier matériau pendant la phase de solidification de celui-ci. Ces moyens peuvent être un ressort agissant sur la partie mobile du moyen de moulage ou, lorsque la partie mobile du moyen de moulage est un piston mobile verticalement, un lest posé sur ce piston. Bien entendu, les moyens permettant d'exercer une force sur le premier matériau sont applicables quand la solidification du premier matériau s'accompagne d'une variation de volume.

L'invention apparaîtra mieux à la lecture de la description qui va suivre, donnée à titre d'exemple purement illustratif et nullement limitatif, en référence aux dessins annexés, dans lesquels :

- la figure 1 est une vue schématique en perspective illustrant la formation d'une goutte de silicium dans un bain liquide protecteur ;

- la figure 2 est une vue semblable à la figure 1 montrant l'extraction de la plaque de silicium une fois solidifiée ;

- les figures 3 à 5 décrivent la fabrication d'une plaque lorsque le premier matériau à l'état liquide a une densité supérieure à celle du deuxième matériau à l'état liquide ;

- la figure 6 est une vue schématique en coupe verticale illustrant un moyen d'exercer une force sur le premier matériau pendant sa solidification ;

- la figure 7 est une vue schématique en perspective montrant des griffes utilisables pour extraire le premier matériau une fois solidifié, et

- la figure 8 est une vue schématique en perspective montrant une cuve à parois détachables utilisée lorsqu'on extrait la pièce réalisée après solidification complète des deux matériaux.

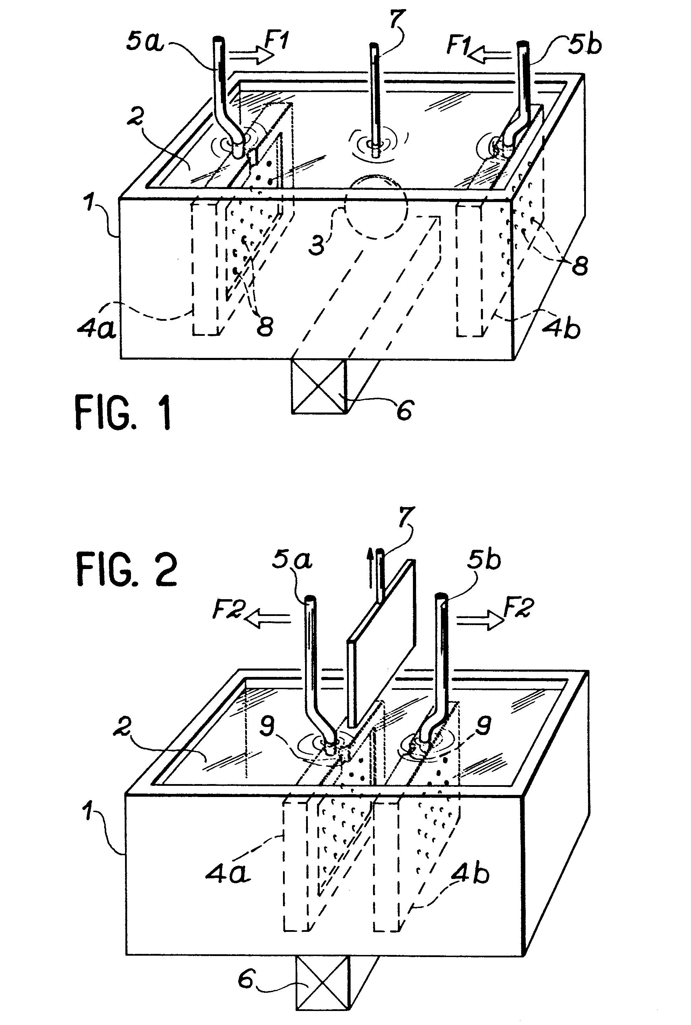

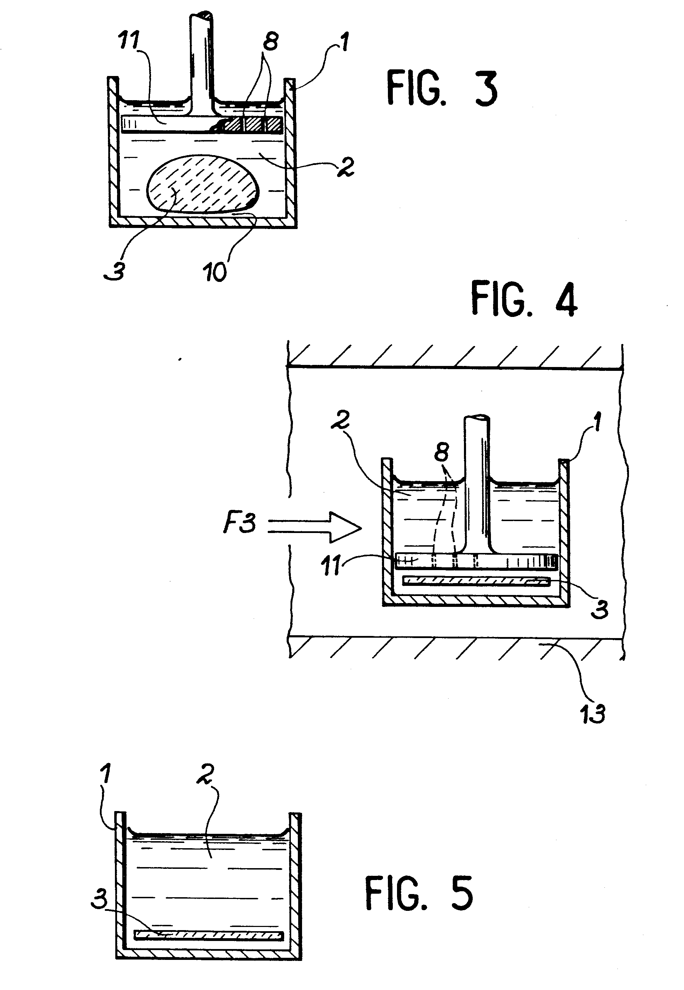

Dans le cas des figures 1 et 2, le moyen de moulage comporte deux parties déplaçables l'une vers l'autre à l'intérieur de la cuve. Dans le cas des figures 3 à 8, le moyen de moulage comporte un piston déplaçable verticalement en direction du fond de la cuve.

Sur la figure 1, on voit que le dispositif conforme à l'invention se compose d'une cuve 1 à l'intérieur de laquelle se trouve le liquide protecteur 2. Dans le cas d'élaboration de silicium, on a intérêt à choisir un mélange de fluorures de calcium et de magnésium qui assure une bonne protection lorsque les parois du moule sont par exemple en graphite. Cependant, on a intérêt à choisir la composition eutectique qui correspond à 55,6% en poids de fluorure de calcium et dont le point de fusion est de 980°C, alors que la température de fusion du silicium est de 1412°C. De plus, la densité de cet eutectique au point de fusion du silicium est voisine de la densité de celui-ci à cette température. A l'intérieur de la cuve 1 se trouve un moyen de moulage qui, dans l'exemple particulier décrit ici, se compose de deux plaques 4a et 4b reliées par des tiges support 5a et 5b respectivement à des moyens de déplacement (non représentés) qui permettent de les déplacer à l'intérieur de la cuve 1 et de les rapprocher ou de les écarter l'une de l'autre. Ces moyens de déplacement peuvent être pourvus, si nécessaire, de moyens exerçant une force de compensation sur le premier matériau.

Pour réaliser le moulage d'une plaque de silicium à l'aide de ce dispositif, on commence par réa-

liser une masse homogène ou une goutte 3 de ce matériau à l'intérieur du bain liquide 2. Pour cela, on peut par exemple introduire une masse solide de silicium dans le mélange eutectique 2, puis augmenter la température jusqu'à ce qu'on atteigne la température de fusion du silicium, la masse solide se liquéfiant et restant homogène par effet de capillarité. La goutte peut être formée à partir de grenaille ou de poudre de silicium en poids déterminé puis mélangée à l'eutectique en poudre. L'agglomération en une seule masse se produit invariablement à la fusion des composants. La goutte peut aussi être formée par fusion progressive de l'extrémité d'un lingot de silicium de dimensions bien définies et non immergé dans le bain. Par l'effet de la pesanteur, des gouttes de volume constant se détachent du lingot et tombent dans le bain ; le moulage se fait ensuite en rapprochant l'une de l'autre les plaques 4a et 4b (déplacement dans le sens des flèches F1) de manière à emprisonner la goutte 3 et à lui donner la forme voulue. On peut déplacer l'une et/ou l'autre des plaques percées : la goutte de silicium liquide se maintient à l'intérieur du liquide protecteur 2 en équilibre proche de l'équilibre indifférent pendant qu'on rapproche les deux parties 4a et 4b du moyen de moulage. On remarque encore sur la figure 1 que les deux éléments 4a et 4b sont percés de trous 8 de diamètre tel qu'ils permettent l'écoulement du matériau 2 pendant le déplacement des plaques 4a et 4b mais interdisent l'écoulement du silicium lui-même. On arrive ainsi à une situation où le silicium est mis en forme dans la cavité constituée par les plaques, tout en étant séparé des parois de celles-ci par un film liquide du matériau 2, ce qui évite des interactions entre le silicium et le moyen de moulage.

On procède ensuite au refroidissement à l'aide du dispositif de refroidissement 6 qui permet

une solidification orientée. Celui-ci peut être constitué d'un tube dans lequel est admis le moment venu un fluide de refroidissement ou d'une masse conductrice de la chaleur mise en contact thermique avec un puits froid.

La présence du dispositif 6 sous la cuve 1 permet de refroidir et de solidifier en premier lieu la couche inférieure de la plaque de silicium puis, de proche en proche, les autres couches. Lorsque la totalité de la plaque de silicium est solidifiée, la température restant toutefois à une valeur suffisante pour que le liquide protecteur 2 soit encore liquide, on écarte les parties 4a et 4b du moule en déplaçant les tiges 5a et 5b dans le sens des flèches $F_2$ (figure 2) et on extrait la plaque de silicium.

Afin de faciliter cette dernière opération, dans le cas du silicium, on a prévu à la partie supérieure des plaques 4a et 4b des cavités de forme semicylindrique 9 qui permettent de contenir le volume de silicium en excès provenant de la solidification une fois que les plaques 4a et 4b sont en contact l'une avec l'autre. Une tige d'extraction 7 est positionnée dans cette cavité et entre en contact avec le silicium en excès. La solidification complète du silicium a pour effet de fixer la plaque à l'extrémité inférieure de la tige 7 par collage, ce qui permet d'extraire plus facilement la plaque de la cuve 1. On attend ensuite que la tige et la plaque soient complètement refroidies, c'est-à-dire jusqu'à la température ambiante, pour séparer la tige et le volume en excès de la plaque elle-même. Si après extraction du bain il reste encore des pellicules du matériau protecteur sur la surface de la plaque de silicium, celles-ci sont éliminées par tout procédé chimique ou physique approprié, par exemple par décapage acide.

A titre d'essai, on a réalisé des plaques de silicium avec un dispositif comparable à celui des figures 1 et 2, dans lequel la cuve 1 était une cuve en graphite de dimensions intérieures 6 cm x 4 cm pour une hauteur de 7 cm. Les plaques 4a et 4b étaient en graphite de haute pureté et percées de trous de diamètre 0,5 mm. Les plaques avaient une forme telle qu'elles définissaient une cavité de 5 cm x 5 cm de côté pour une profondeur de 0,1 cm. Dans tous les cas, le diamètre des trous 8 doit être inférieur à l'épaisseur de la plaque à élaborer pour éviter que le silicium ne s'échappe à travers ces trous. Quant au matériau protecteur 2, c'était le mélange eutectique de fluorures de calcium et de magnésium dont la densité est légèrement inférieure à celle du silicium liquide.

Les figures 3 à 5 décrivent la fabrication d'une plaque lorsque le moyen de moulage est constitué par un piston mobile à l'intérieur de la cuve en direction d'une partie fixe de cette dernière.

On reconnait sur la figure 3 la cuve 1 qui, ici, a les parois mouillées préférentiellement par le deuxième matériau liquide 2, ainsi qu'une goutte du premier matériau 3 plus dense et reposant donc sur un film 10 du deuxième matériau.

Le piston mobile 11 du moyen de moulage, pourvu d'orifices 8, constitué du même matériau que la cuve, est alors descendu jusqu'à une hauteur déterminée, afin de comprimer la goutte du premier matériau 3 jusqu'à la formation d'une plaque du premier matériau, comme montré sur la figure 4. Les orifices 8, ménagés dans le piston 11, permettent l'écoulement du seul deuxième matériau pendant la descente du piston. La forme de la pièce à réaliser est déterminée par la forme de la cavité définie par le piston 11 et le fond de la cuve 1.

La solidification dirigée peut alors commencer et s'effectuer par tout moyen conventionnel : on peut par exemple placer l'ensemble cuve-piston dans un four à défilement 13 dans lequel est prévu un gradient thermique, cet ensemble cuve-piston se déplaçant dans le sens de la flèche F3. Après solidification du premier matériau 3, on l'extrait du deuxième matériau 2 par tout moyen approprié.

Le mode de mise en oeuvre illustré aux figures 3 à 5 permet la fabrication d'objets de dimensions raisonnables, l'utilisation d'un moyen de moulage à parois verticales ne permettant d'obtenir dans ce cas, que des pièces de faible hauteur. Grâce au mode de mise en oeuvre des figures 3 à 5, on a réalisé des plaques rectangulaires (5x5cm) d'alliage InSb en utilisant une cuve et un piston en quartz, au moyen d'un bain protecteur formé de l'eutectique chlorures de lithium et de potassium à 56% en poids de KCL. Pour des plaques d'alliages GaAs (3x3 cm) on peut employer un bain protecteur de trioxyde de bore avec une cuve et un piston en quartz ou en nitrure de bore.

On voit donc que l'invention permet d'élaborer facilement et rapidement un matériau de forme voulue, celui-ci étant séparé des parois du moule par un liquide protecteur tout au long de la phase de solidification.

Un problème peut se poser lorsque le premier matériau voit son volume varier durant la solidification, par exemple augmenter de volume en se solidifiant, comme c'est le cas avec le silicium, ce qui rend délicat le moulage de volumes importants. Cette opération nécessite alors une compensation de la variation de volume à la solidification pour maintenir les formes désirées avec une précision suffisante.

Pour cela, un mode de solidification doit être choisi pour localiser le volume créé à la solidi-

fication dans le dispositif de compensation. Ce dernier peut être constitué par la partie mobile du moyen de moulage utilisée pour confiner le matériau liquide. La variation de volume à la solidification doit alors être accompagnée d'un déplacement de la partie mobile tout en conservant la pression d'appui constante et calibrée nécessaire pour assurer le moulage dans la forme désirée.

Cette pression d'appui dépend essentiellement des rayons de courbure moyens minimum de la forme moulée à l'état liquide lorsque les densités du matériau 2 et 3 sont très voisines ou lorsqu'on opère en micro-gravité.

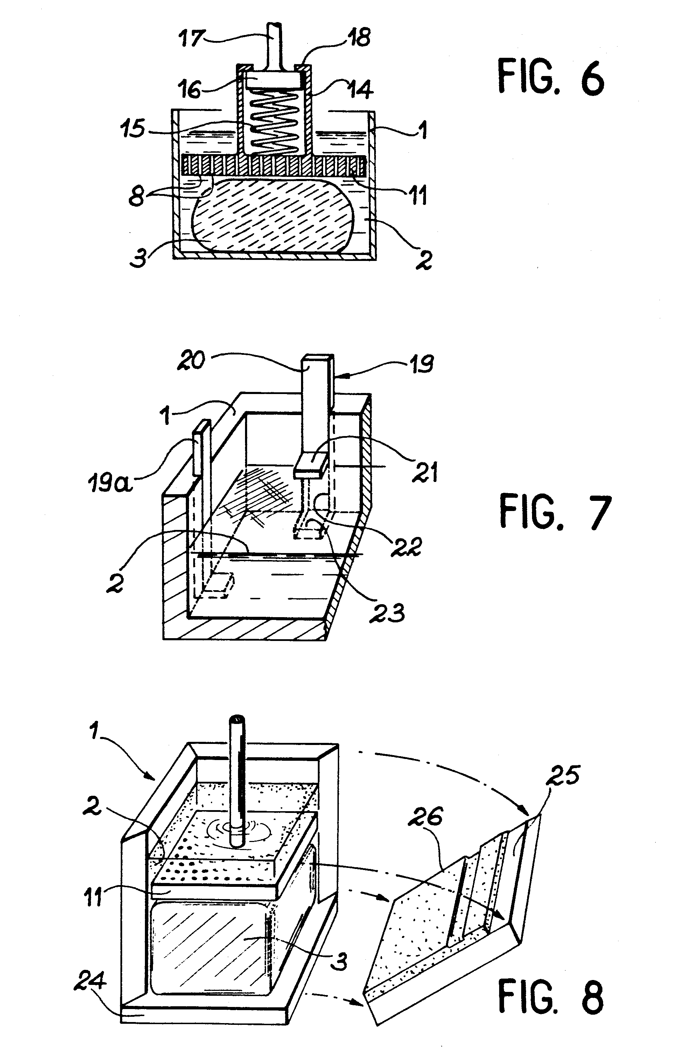

Si la partie mobile du moyen de moulage est un piston déplaçable verticalement, on peut utiliser un lest calibré posé sur le piston. On peut aussi utiliser un ressort comme cela est illustré à la figure 6.

On retrouve sur cette figure la cuve 1 qui contient une masse liquide 2 du deuxième matériau, la masse liquide homogène 3 du premier matériau se trouvant dans la cuve. Le piston 11, percé de trous 8 comme dans le cas de la figure 3, est équipé d'un tube de protection et de guidage 14 à l'intérieur duquel se trouve un ressort 15. Ce dernier peut être en graphite lorsqu'on opère à haute température. Une pièce 16, solidaire d'une tige de commande 17, est prévue à la partie supérieure du tube 14 et elle est maintenue par un rebord 18 de ce dernier.

Lorsqu'au cours de la solidification, le silicium augmente de volume, ceci a pour effet de déplacer vers le haut l'ensemble constitué par le piston 11 et le tube 14 et, comme la tige 17 et la pièce 16 sont fixes, le ressort 15 est comprimé et la force d'appui sur le silicium augmente.

B 7812.3 JR

La lubrification du mouvement du piston est assurée par la présence d'un film du deuxième matériau fondu entre les surfaces mobiles et créé par la montée capillaire de ce deuxième matériau.

Dans le cas du moulage de silicium en lingot parallélépipédique de grand volume en milieu eutectique de fluorure alcalino terreux isodensité, la variation de volume, qui est d'environ 11%, est compensée par le déplacement du piston. La solidification est généralement réalisée de bas en haut et une pression de l'ordre de 200 Pa donne de très bons résultats.

Lorsque la plaque de silicium ou autre est moulée dans le fond de la cuve, l'extraction peut être réalisée à chaud en utilisant des griffes d'extraction comme celles qui sont illustrées à la figure 7. On voit sur cette figure que chaque griffe 19 comporte un montant 20 et un pied 21 qui lui est sensiblement perpendiculaire. Le montant 20 peut coulisser dans une rainure ou glissière 22 ménagée sur la face interne d'une paroi de la cuve tandis que le pied 21 peut être reçu dans un logement 23 ménagé dans le fond de la cuve. Les dimensions de ces éléments sont telles que, lorsque la griffe est en place comme la griffe 19a à gauche de la figure, il n'y a pas de discontinuité sur les faces internes des parois de la cuve, ni sur le fond. Après solidification complète du premier matériau, le deuxième étant toujours liquide, les griffes sont relevées simultanément par un système de levage (non représenté) et entraînent la plaque ou le lingot réalisé hors de la cuve. Les griffes sont de préférence au nombre de trois, mais ce nombre peut varier en fonction de chaque cas particulier.

Il arrive que l'extraction de volumes moulés importants ne puisse se faire à chaud par l'une ou l'autre des méthodes précédemment décrites. Dans ce

B 7812.3  JR

cas, l'extraction de la pièce moulée doit être faite après solidification complète des deux matériaux.

Lorsqu'on moule une pièce en silicium avec un mélange de fluorures de calcium et de magnésium comme matériau protecteur, il est avantageux d'utiliser une cuve démontable en graphite comme celle qui est représentée sur la figure 8.

On voit sur cette figure que la cuve 1 se compose d'un fond 24 et de plusieurs parois détachables 25. Ces dernières sont assemblées avec le fond 24 grâce à un montage classique non représenté.

Le fonctionnement d'un tel dispositif est le suivant :

Les parois de la cuve étant en position relevée, on moule la pièce 3 par abaissement du piston 11 monté avec le dispositif de compensation de volume non représenté (voir figure 6). On laisse solidifier le premier matériau, puis le deuxième. On détache alors les parois de la cuve, on sépare le piston et on libère ainsi le volume massif de silicium de la masse de sel dans laquelle il était noyé. Cette opération est facilitée par le fait que les propriétés de mouillage du deuxième matériau 2 vis-à-vis du graphite constituant la cuve et vis-à-vis du silicium entraînent une non-adhérence sur le silicium solide et une forte adhérence sur les parois de la cuve. La totalité du deuxième matériau reste donc sur les parois lorsqu'on détache ces dernières, ainsi que sur le piston, comme la couche 26 visible sur la figure 2. Le démontage est facilité en donnant de légers chocs sur les parois de la cuve. La cuve et les sels adhérents peuvent être réutilisés ultérieurement.

Il est à remarquer que, de manière surprenante, il n'est pas nécessaire de prévoir une étanchéité entre les parois de la cuve lorsque celles-ci

sont en position relevée si la cuve est en graphite et si le deuxième matériau est un mélange de fluorures de calcium et de magnésium. En effet, les inventeurs ont remarqué que les propriétés de mouillage préférentiel de ce mélange vis-à-vis du graphite exposé aux milieux fondus et de non-mouillage vis-à-vis du graphite non exposé rendent inutile la présence d'un joint à la jonction des parois et du fond de la cuve. Ceci simplifie la construction de l'appareil et rend plus rapide une opération de moulage.

Il est cependant bien entendu que l'invention ne se limite pas aux seuls exemples qui viennent d'être décrits mais qu'on peut imaginer des variantes sans sortir pour autant du cadre de l'invention. Par exemple, si dans le cas des figures 1 et 2, le moule est un moule en deux parties ayant la forme de plaques, on peut imaginer d'autres formes suivant l'objet à réaliser, le nombre d'éléments du moule que l'on déplace à l'intérieur de la cuve pouvant être quelconque, suivant les applications envisagées. D'autre part, le matériau constituant le bain liquide 2 peut être quelconque, pourvu que sa température de fusion soit inférieure à celle du matériau à élaborer et qu'il assure une bonne protection vis-à-vis des parois du moule.

REVENDICATIONS

1. Procédé d'élaboration par moulage d'une pièce en un premier matériau (3), caractérisé en ce qu'il comprend les étapes suivantes :
- on forme, dans une cuve (1) contenant un moyen de moulage, une masse liquide homogène du premier matériau (3) enrobé par un bain liquide d'un deuxième matériau (2) non miscible avec le premier matériau, ce deuxième matériau (2) ayant une température de fusion inférieure à celle du premier matériau (3) et présentant une grande inertie chimique vis-à-vis du premier matériau (3) et un pouvoir mouillant vis-à-vis du moyen de moulage supérieur à celui du premier matériau,
- on comprime cette masse (3) par le rapprochement d'au moins deux parties (4a, 4b) d'un moyen de moulage, l'une au moins de ces dernières présentant au moins une paroi percée de trous (8) et ayant une forme telle qu'en position rapprochée les deux parties (4a, 4b) définissent une cavité ayant la forme de l'objet à élaborer,
- on abaisse la température pour qu'au moins le premier matériau (3) se solidifie, et
- on extrait la pièce ainsi solidifiée.

2. Procédé d'élaboration par moulage d'une pièce selon la revendication 1, caractérisé en ce qu'on extrait la pièce réalisée alors que le deuxième matériau est encore à l'état liquide.

3. Procédé d'élaboration par moulage d'une pièce selon la revendication 1, caractérisé en ce qu'on extrait la pièce réalisée après solidification complète du premier et du deuxième matériaux.

4. Procédé d'élaboration par moulage d'une pièce selon la revendication 3, caractérisé en ce

B 7812.3   JR

qu'après solidification complète du deuxième matériau, on détache au moins une paroi de la cuve pour extraire le premier matériau.

5. Procédé d'élaboration par moulage d'une pièce selon l'une quelconque des revendications 1 à 4, caractérisé en ce que les premier et deuxième matériaux ont des densités voisines lorsqu'ils sont à l'état liquide.

6. Procédé d'élaboration par moulage d'une pièce selon l'une quelconque des revendications 1 à 4, caractérisé en ce que les premier et deuxième matériaux ont des densités respectives quelconques lorsqu'ils sont à l'état liquide.

7. Procédé d'élaboration par moulage d'une pièce selon l'une quelconque des revendications 1 à 4, caractérisé en ce que le premier matériau a une densité supérieure à celle du deuxième matériau.

8. Procédé d'élaboration par moulage d'une pièce selon l'une quelconque des revendications 1 à 7, caractérisé en ce que le premier matériau est un semiconducteur.

9. Procédé d'élaboration par moulage d'une pièce selon l'une quelconque des revendications 1 à 8, caractérisé en ce que le premier matériau est du silicium.

10. Procédé d'élaboration par moulage d'une pièce selon la revendication 9, caractérisé en ce que le deuxième matériau (2) est un mélange de fluorure de calcium et de fluorure de magnésium.

11. Procédé d'élaboration par moulage d'une pièce selon la revendication 10, caractérisé en ce que la composition du mélange de fluorure de calcium et de fluorure de magnésium correspond à la composition eutectique.

12. Procédé d'élaboration par moulage d'une pièce selon la revendication 9, caractérisé en ce que le moyen de moulage est en graphite.

B 7812.3 JR

13. Procédé d'élaboration par moulage d'une pièce selon l'une quelconque des revendications 9 à 12, caractérisé en ce que, le premier matériau étant du silicium, l'extraction de ce dernier se fait par mise en contact d'une tige avec une partie encore liquide du premier matériau (3) en fin de solidification, en laissant solidifier cette partie du premier matériau (3) pour réaliser une fixation par collage sur la tige (7), et en extrayant le premier matériau (3) du moule par l'intermédiaire de cette tige (7).

14. Procédé d'élaboration par moulage d'une pièce selon la revendication 13, caractérisé en ce que le matériau constituant ladite tige d'extraction (7) est choisi dans le groupe constitué par les métaux réfractaires et les oxydes réfractaires, préférentiellement mouillés par le premier matériau.

15. Procédé d'élaboration par moulage d'une pièce selon l'une quelconque des revendications 1 à 7, caractérisé en ce que le premier matériau est un alliage des éléments des groupes III-V de la classification périodique.

16. Procédé d'élaboration par moulage d'une pièce selon la revendication 15, caractérisé en ce que le deuxième matériau est choisi dans le groupe constitué par le trioxyde de bore et l'eutectique chlorure de potassium et de lithium.

17. Procédé d'élaboration par moulage d'une pièce selon la revendication 15, caractérisé en ce que le moyen de moulage est réalisé dans un matériau choisi dans le groupe constitué par le quartz et le nitrure de bore.

18. Procédé d'élaboration par moulage d'une pièce selon l'une quelconque des revendications 1 à 17, caractérisé en ce que l'étape de solidification du premier matériau (3) se fait par solidification orientée.

B 7812.3   JR

19. Application du procédé selon l'une quelconque des revendications 1 à 18 à l'élaboration de matériaux en microgravité.

20. Dispositif pour la mise en oeuvre du procédé selon l'une quelconque des revendications 1 à 19, caractérisé en ce qu'il comprend :
- une cuve (1) apte à contenir le deuxième matériau (2),
- des moyens de chauffage du deuxième matériau,
- des moyens de formation d'une masse liquide du premier matériau (3) dans le bain liquide du deuxième matériau (2),
- un moyen de moulage dont au moins une partie (4a) est déplaçable entre une position de repos et une position de moulage, ledit moyen de moulage (4a, 4b) présentant au moins une paroi percée de trous (8),
- des moyens de déplacement de ladite partie mobile (4a) entre la position de repos et la position de moulage,
- des moyens de refroidissement pour la solidification d'au moins le premier matériau, et
- des moyens d'extraction du premier matériau une fois solidifié.

21. Dispositif selon la revendication 20, caractérisé en ce que le moyen de moulage comprend deux parties (4a, 4b) déplaçables à l'intérieur de la cuve (1).

22. Dispositif selon la revendication 20, caractérisé en ce que le moyen de moulage comprend un piston (11) déplaçable en direction d'une partie fixe de la cuve (2).

23. Dispositif selon la revendication 22, caractérisé en ce que les moyens d'extraction du premier matériau une fois solidifié comprennent au moins une griffe (19) comportant un montant (20) et un pied

(21), le montant (20) pouvant coulisser dans une glissière (22) prévue sur la face interne d'une paroi de la cuve (1) et le pied (21) pouvant être reçu dans un logement (23) ménagé sur le fond de la cuve.

24. Dispositif selon la revendication 20, caractérisé en ce que la cuve (1) comporte un fond (24) et au moins une paroi (25) détachable du fond (24), permettant l'extraction de la pièce réalisée après solidification complète du premier et du deuxième matériaux.

25. Dispositif selon l'une quelconque des revendications 20 à 24, caractérisé en ce qu'il comporte des moyens permettant d'exercer une force calibrée sur le premier matériau pendant la solidification de celui-ci.

26. Dispositif selon la revendication 25, caractérisé en ce que lesdits moyens permettant d'exercer une force sur le premier matériau comprennent un ressort (15) agissant sur la partie mobile (11) du moyen de moulage.

27. Dispositif selon la revendication 25, caractérisé en ce que, la partie mobile du moyen de moulage étant un piston (11) mobile verticalement, les moyens d'exercer une force sur le premier matériau comprennent un lest posé sur ledit piston (11).

0136197

1/3

FIG. 1

FIG. 2

0136197

FIG. 3

FIG. 4

FIG. 5

F3

FIG. 6

FIG. 7

FIG. 8

**Office européen des brevets**

## RAPPORT DE RECHERCHE EUROPEENNE

Numéro de la demande

EP 84 40 1540

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-4 356 141 (A. SANJURJO)<br><br>* Colonnes 1,2; revendication 1 * | 1-3,6-9,12, 20,22, 25,27 | C 30 B 11/00<br>C 30 B 27/00 |
| | --- | | |
| A | US-A-2 875 108 (W. PFANN)<br><br>----- | | |

**DOMAINES TECHNIQUES RECHERCHES (Int. Cl.4)**

C 30 B 11/00
C 30 B 27/00
C 30 B 29/60

Le présent rapport de recherche a été établi pour toutes les revendications

| Lieu de la recherche | Date d'achèvement de la recherche | Examinateur |
|---|---|---|
| LA HAYE | 19-11-1984 | BRACKE P.P.J.L. |